# EUROPEAN PATENT APPLICATION

(11) **EP 4 650 871 A1**
(43) Date of publication of application: **19.11.2025**
(21) Application number: 24175342.5
(22) Date of filing: 13.05.2024
(51) Int. Cl.: G03F 7/00, H01L 21/687

(54) **OBJECT SUPPORT AND ARRANGEMENT THEREOF**

(71) Applicant: ASML Netherlands B.V., 5500 AH Veldhoven (NL)
(72) Inventor: KEMPEN, Antonius, Theodorus, Wilhelmus, 5500 AH Veldhoven (NL); BECKERS, Johan, Franciscus, Maria, 5500 AH Veldhoven (NL)
(74) Representative: ASML Netherlands B.V.

(57) **Abstract**

An object support comprising a generally planar body having a first surface and having a second surface opposite to the first surface, wherein a first set of burls extend from the first surface and a second set of burls extend from the second surface, and wherein a layer is provided at distal ends of at least some of the second set of burls, the layer having a static water contact angle of at least 70°.

## Description

### FIELD

The present invention relates to an object support and an object supporting arrangement. The object support and arrangement thereof may form part of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm (KrF), 193 nm (ArF) and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

A substrate which is being patterned by a lithographic apparatus is held on an object support. The object support includes a generally planar body which is configured to securely hold the substrate on the object support whilst the substrate is being patterned, and then to allow the substrate to be removed from the generally planar body once patterning has been completed. The object support may form part of an object table. The object table includes a base which couples the object support to means for controlling the position and velocity of the object support. In some lithographic apparatus, the base may be a mirror block (i.e., include mirrors on its sides) so as to enable interferometric metrology. The object support typically abuts the base via projecting burls.

The object support may be clamped to the base during exposure of a substrate. Clamping of the object support to the base may be achieved by generating a vacuum between the generally planar body and the base. The clamping may also be achieved by electrostatic forces between the body and the base.

A problem which may arise in connection with object supports is that it may be difficult to ensure that the object support is clamped sufficiently strongly to avoid slipping or relative displacement of the burls (and the object support) relative to the base during high acceleration of the object table. Distal ends of the burls may be provided with a surface having a roughness which provides a desired amount of friction in order to reduce or prevent this slipping or relative displacement.

Another problem which may arise is that the burls of the object support may remain stuck to the base after the vacuum between the object support and the base has been removed. In other words, clamping force is no longer being applied but the burls nevertheless continue to adhere to the base. This is undesirable because the object support may have expanded to a distorted shape during exposure of a substrate (due to heating during exposure). It is desirable that the object support relaxes to its original shape before another substrate is loaded onto the object support. However, if the burls continue to adhere to the base then this will not happen. The undesired adhesion of the burls to the base may be reduced or prevented by providing distal ends of the burls with a surface which provides a lower amount of friction. However, this then increases the risk of burl slipping or relative displacement during substrate exposure.

It may be desirable to provide an object support which address the above problem in a manner which is not disclosed or suggested by the prior art.

### SUMMARY

According to a first aspect of the invention there is provided an object support comprising a generally planar body having a first surface and having a second surface opposite to the first surface, wherein a first set of burls extend from the first surface configured to support a substrate and a second set of burls extend from the second surface, and wherein a layer is provided at distal ends of at least some of the second set of burls, the layer having a static water contact angle of at least 70°.

Advantageously, the layer reduces or prevents capillary adhesion forces which would cause undesirable sticking of the burls to a surface which is in contact with the burls.

The layer may have a static water contact angle of at least 90°.

The layer may be formed from monomers.

The layer may be a hexamethyldisilazane (HMDS) based coating, or a coating comprising PTFE (polytetrafluoroethylene), TEOS (tetra orthosilicate), or PDMS (polydimethylsiloxane).

The layer may be formed from polymers of rare earth metaloxide.

The layer may be provided at distal ends of all of the second set of burls.

The second set of burls may have a higher density than the first set of burls.

The layer may be provided in areas of the second surface that are located between the second set of burls.

The layer may have a thickness of at least 5 nm.

According to a second aspect of the invention there is provided an object table comprising a base having a planar surface, and an object support comprising a generally planar body having a set of burls which extend from the generally planar body and are in contact with the base, wherein a layer is provided on distal ends of at least some of the burls and/or on the planar surface of the base, the layer having a static water contact angle of at least 70°.

Advantageously, the layer reduces or prevents capillary adhesion forces which would cause undesirable sticking of the burls or the planar surface to a surface which is in contact with the burls or the planar surface.

According to a third aspect of the invention there is provided an object table comprising a base which defines a rectangular window and includes an object supporting surface, wherein a layer is provided on the object supporting surface, the layer having a static water contact angle of at least 70°.

Advantageously, the layer reduces or prevents capillary adhesion forces which would cause undesirable sticking between an object and the object supporting surface.

The layer may be provided at distal ends of burls which extend from the object supporting surface.

The layer may be provided at locations on the object supporting surface which are configured to receive burls of an object supported by the object table.

The layer of the second or third aspect may have a static water contact angle of at least 90°.

The layer of the second or third aspect may be formed from monomers.

The layer of the second or third aspect may be formed from polymers of rare earth metaloxide.

The layer of the second or third aspect may be a hexamethyldisilazane (HMDS) based coating, or a coating comprising PTFE (polytetrafluoroethylene), TEOS (tetra orthosilicate), or PDMS (polydimethylsiloxane).

According to a fourth aspect of the invention there is provided a semiconductor manufacturing apparatus comprising the object support or the object table according to any preceding claim

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source, and including an object support according to an embodiment of the invention;
- Figure 2 schematically depicts an object table in the form of a substrate table according to an embodiment of the invention;
- Figure 3 schematically depicts a burl of an object support according to an embodiment of the invention;
- Figure 4 schematically depicts an object table in the form of a substrate table according to an alternative embodiment of the invention;
- Figure 5 schematically depicts an object table in the form of a mask table according to an embodiment of the invention;
- Figure 6 schematically depicts part of an object table in the form of a mask table according to an alternative embodiment of the invention; and
- Figure 7 schematically depicts part of an object table in the form of a mask table according to an alternative embodiment of the invention.

### DETAILED DESCRIPTION

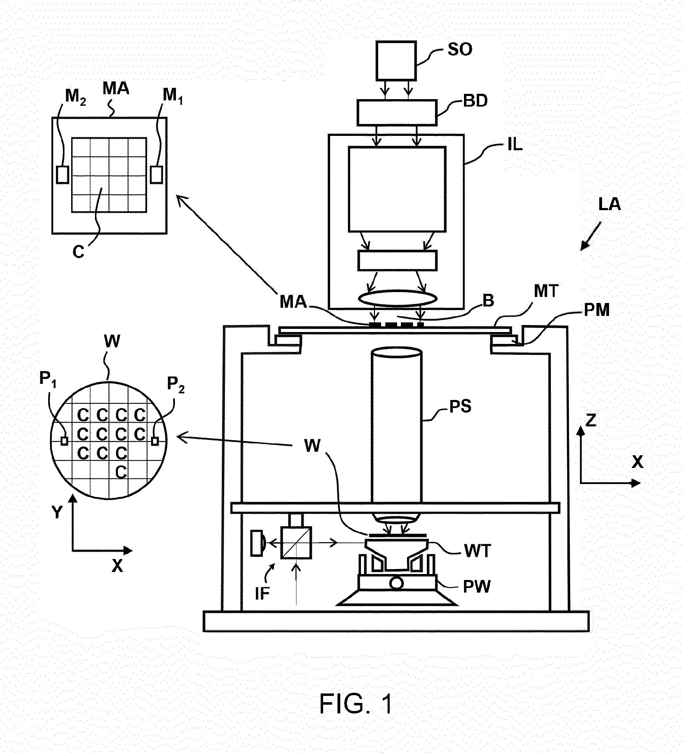

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask table MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography.

The lithographic apparatus LA may also be of a type (not depicted) having two or more substrate supports (also named "dual stage"). In such "multiple stage" machine, the substrate supports may be used in parallel, and/or steps in preparation of a subsequent exposure of the substrate W may be carried out on the substrate W located on one of the substrate support while another substrate on the other substrate table WT is being used for exposing a pattern on the other substrate.

In operation, the radiation beam B is incident on the patterning device, e.g. mask, MA which is held on the mask table MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate table WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

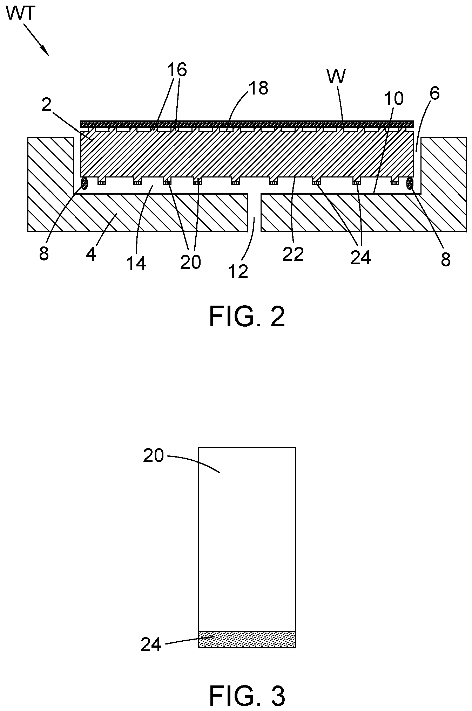

Figure 2 schematically depicts in cross section a substrate table WT according to an embodiment of the invention. The substrate table WT is an example of an object table. The substrate table WT comprises a substrate support 2 and a base 4. For ease of illustration the substrate support 2 is separated from the base 4, whereas in use the substrate support 2 is in contact with the base 4. The base 4 may comprise a recess 6, which receives (or is configured to receive) the substrate support 2. The substrate support 2 has a generally planar body. The substrate support 2 may be made of alumina (Al₂O₃), aluminium nitride (AlN), silicon carbide (SiC), or SiSiC, a ceramic material having silicon carbide grains in a silicon matrix. The substrate support 2 may be generally circular when viewed from above. Similarly, the recess 6 may be generally circular when viewed from above. In some embodiments the recess 6 may be omitted, in which case the base 4 may have a flat upper surface which extends fully across the base or at least at the area configured to receive the substrate support 2. A seal (or sealing member) 8 may be provided on the substrate support 2 at a surface 22 facing the base 4. The seal 8 may be provided as a closed-loop, for example in the form of a ring. The seal is a deformable seal, especially an elastic seal.

According to an embodiment, the seal is provided at the base 4. For example, the seal 8 may be provided at a floor 10 (not illustrated). The seal 8 at the floor 10 may be provided as a closed-loop, for example in the form of a ring. The seal is a deformable seal, especially an elastic seal.

A gas conduit 12 extends through the floor 10. In use, gas (e.g., air) may be pumped from a volume between the substrate support 2 and the floor 10 of the base 4. This pulls the substrate support 2 towards the floor 10 of the base 4, and engages the substrate support with the seal 8. A vacuum is established in a volume 14 between the substrate support 2 and the floor 10 of the base 4. This vacuum secures the substrate support 2 to the base 4. The volume 14 may be referred to as a clamping volume 14.

A plurality of upper burls 16 extend from an upper surface 18 of the substrate support 2. The upper burls 16 are arranged (or configured) to support a substrate W. A substrate W is retained on these burls 16 (e.g., using a vacuum or electrostatic attraction) during use. The upper burls 16, which extend from the upper surface 18 of the substrate support 2, may be referred to as a first set of burls 16. The upper surface 18 of the substrate support 2 may be referred to as a first surface of the substrate support. The first set of burls (or upper burls) 16 may comprise the same material as the substrate support 2.

The distal ends of the upper burls 16 may be provided with a wear resistant coating (not illustrated). The wear resistant coating may comprise a CrN layer, a diamond-like carbon (DLC) layer, or a diamond layer, for example a layer comprising poly-, micro-, meso-, nano-, or ultranano-crystalline diamond. The wear resistant layer may be provided by means of chemical vapor deposition (CVD) at a relative low temperature (e.g., 350 to 599°C) or at a relative high temperature (e.g., 600 to 800°C).

A plurality of (bottom) burls 20 extend from a bottom surface 22 of the substrate support 2. The burls 20 engage with the floor 10 of the base 4. When there is no vacuum in the clamping volume 14, the burls rest upon the floor 10 due to gravity. When a vacuum is established in the clamping volume 14, the burls 20 are pulled against the floor 10 by force due to the vacuum.

The burls 20 which extend from the bottom surface 22 of the substrate support 2 may be referred to as a second set of burls 20. The bottom surface 22 of the substrate support 2 may be referred to as a second surface of the substrate support. The first set of burls 16 may have a higher density than the second set of burls 20. In this context, the term 'density' is intended to mean the number of burls per unit area of the substrate support 2.

At least a portion of distal ends of the burls 20 are provided with a layer 24. The layer 24 has a static water contact angle of at least 70°. The layer 24 may be referred to as hydrophobic. The layer 24 may have a static water contact angle of at least 90°.

The layer 24 may be formed from monomers. The layer 24 may be a hexamethyldisilazane (HMDS) based coating, or a coating comprising PTFE (polytetrafluoroethylene), TEOS (tetra orthosilicate), or PDMS (polydimethylsiloxane). The layer 24 may be from a coating group family such as: fluorinated (Sol-gel) coatings, hydro carbon or fluorinated silanes, or rare earth oxides (ROE). The layer may be formed from polymers of rare earth metaloxide.

The layer 24 advantageously reduces adhesion of the burls 20 to the floor 10 when the vacuum is removed from the clamping volume 14. When the vacuum is removed from the clamping volume 14, air returns to that volume. The air contains some water, and some of the water will be incident at interfaces between distal ends of the burls 20 and the floor 10. The distal ends of the burls 20 are polished, but still have some roughness. The distal ends of the burls 20 may have a roughness in the order of 2 to 20 nm Sa. This roughness reduces the likelihood of displacement of the burls 20 (and herewith the substrate support 2) on the floor 10 during high acceleration of the substrate table WT. This roughness means that there are microscopic spaces between the distal end of each burl 20 and the floor 10. If the layer 24 was not present, then the water carried by the air would travel into these microscopic spaces between the burls 20 and the floor 10. This water would give rise to capillary adhesion forces. These capillary adhesion forces would cause sticking of the burls 20 to the floor 10. This issue is avoided or substantially reduced by providing the layer 24 at distal ends of the burls 20. The layer 24 has a static water contact angle of at least 70°, and may have a static water contact angle of at least 90°. The layer 24 may be referred to as hydrophobic. The layer 24 prevents water from entering microscopic spaces between the burls 20 and the floor 10 (or reduces the amount of water that enters). As a result capillary adhesion forces do not arise or are reduced. Therefore, adhesion of the burls 20 to the floor 10 is reduced. Advantageously, this may allow the substrate support 2 to relax to its original shape when the vacuum is released from the clamping volume 14.

Figure 3 schematically depicts one of the burls 20 which extends from the bottom surface of the substrate support. Figure 3 also depicts the layer 24 provided at the distal end of the burl. As schematically depicted, the layer 24 may extend fully to edges of the burl 20. The layer may for example have a thickness of 5 nm or more.

In some instances the burl 20 may have a rounded end. Where this is the case, the layer 24 may similarly extend fully across a distal end of the burl. In some embodiments, the layer may extend fully across an area of the distal end of a burl which contacts the floor of the base in use. In some instances the layer 24 may extend not fully to an outer edge of a distal end of a burl.

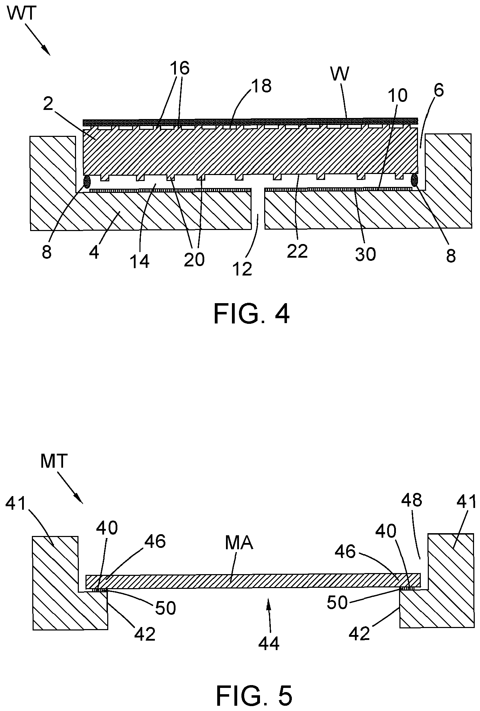

Figure 4 schematically depicts a substrate table WT according to an alternative embodiment of the invention. Features of the embodiment which correspond with features of the embodiment depicted in Figure 2 are provided with the same reference numerals and are not described again.

In this embodiment, a layer is not provided at distal ends of the burls 20. Instead, a layer 30 is provided on the floor 10 of the base 4. The layer 30 has a static water contact angle of at least 70°. The layer 30 may be referred to as hydrophobic. The layer 30 may have a static water contact angle of at least 90°.

The layer 30 may be formed from monomers. The layer 30 may be a hexamethyldisilazane (HMDS) based coating, or a coating comprising PTFE (polytetrafluoroethylene), TEOS (tetra orthosilicate), or PDMS (polydimethylsiloxane). The layer 30 may be from a coating group family such as: fluorinated (Sol-gel) coatings, hydro carbon or fluorinated silanes, or rare earth oxides (ROE). The layer may be formed from polymers of rare earth metaloxide.

The layer 30 provided on the floor 10 of the base 4 works in the same way as the layer 24 described further above at the distal ends of the burls 20. That is, the layer 30 prevents or inhibits water from entering microscopic spaces between the burls 20 and floor 10 of the base 4, and thereby prevents or reduces capillary adhesion forces.

The embodiments of Figures 2, 3 and 4 may be combined. That is, a layer 30 may be provided on the floor 10 and a layer 24 may be provided at distal ends of the burls 20.

Figure 5 schematically depicts in cross section a mask table MT according to an embodiment of the invention. The mask table MT is an example of an object table. The mask table MT comprises a body 41, which is generally rectangular when viewed from above or below. The body 41 includes a recess 48, which is configured to receive a mask MA during use.

The mask table includes a supporting surface 40 provided at or adjacent to an inner edge 42 of the mask table. The mask table MT, when viewed from above or below, has a rectangular opening 44, which is defined by the inner edge 42 of the mask table. The opening 44 acts as a window through which the radiation beam PB (see Figure 1) can pass through the mask table MT having been patterned by the mask MA.

The mask MA is supported by the support surface 40. The support surface 40 forms a rectangular support that supports a peripheral portion 46 of the mask MA. A layer 50 is provided on the mask supporting surface 40. The layer 50 is positioned such that the peripheral portion 46 of the mask MA rests upon the layer 50. Thus, contact between the mask MA and the mask table MT may be solely via the layer 50.

The layer 50 has a static water contact angle of at least 70°. The layer 50 may be referred to as hydrophobic. The layer 50 may have a static water contact angle of at least 90°. The layer 50 may be formed from monomers. The layer 50 may be a hexamethyldisilazane (HMDS) based coating, or a coating comprising PTFE (polytetrafluoroethylene), TEOS (tetra orthosilicate), or PDMS (polydimethylsiloxane). The layer 50 may be from a coating group family such as: fluorinated (Sol-gel) coatings, hydro carbon or fluorinated silanes, or rare earth oxides (ROE). The layer may be formed from polymers of rare earth metaloxide.

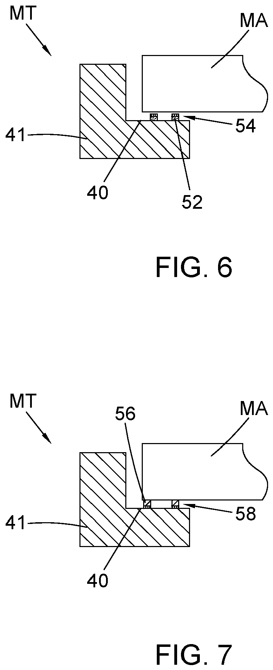

A further alternative embodiment is schematically depicted in Figure 6. Features which are common with the embodiment of Figure 5 are given the same reference numerals and are not described again. Figure 6 schematically depicts part of a mask table MT and a mask MA which is supported by the mask table. The mask table MT comprises a body 41, only part of which is depicted. A support surface 40 of the mask table MT comprises a plurality of burls 52. A layer 54 is provided on a distal end of the burls 52.

The layer 54 has a static water contact angle of at least 70°. The layer 54 may be referred to as hydrophobic. The layer 54 may have a static water contact angle of at least 90°. The layer 54 may be formed from monomers. The layer 54 may be a hexamethyldisilazane (HMDS) based coating, or a coating comprising PTFE (polytetrafluoroethylene), TEOS (tetra orthosilicate), or PDMS (polydimethylsiloxane). The layer 54 may be from a coating group family such as: fluorinated (Sol-gel) coatings, hydro carbon or fluorinated silanes, or rare earth oxides (ROE). The layer may be formed from polymers of rare earth metaloxide.

A further alternative embodiment is schematically depicted in Figure 7. Features which are common with the embodiment of Figure 5 are given the same reference numerals and are not described again. In this embodiment, the mask (or patterning device) MA is provided with (mask) burls 56 or protrusions at the peripheral portion 46. The mask burls 56 are configured to engage with / contact the support surface 40 of the mask table MT. A layer 58 is provided at locations which receive the mask burls 56, or at distal end surfaces of the mask burls 56. In an alternative embodiment, a layer may be provided across an area which receives multiple mask burls 56.

The layer 58 has a static water contact angle of at least 70°. The layer 58 may be referred to as hydrophobic. The layer 58 may have a static water contact angle of at least 90°. The layer 58 may be formed from monomers. The layer 58 may be a hexamethyldisilazane (HMDS) based coating, or a coating comprising PTFE (polytetrafluoroethylene), TEOS (tetra orthosilicate), or PDMS (polydimethylsiloxane). The layer 58 may be from a coating group family such as: fluorinated (Sol-gel) coatings, hydro carbon or fluorinated silanes, or rare earth oxides (ROE). The layer may be formed from polymers of rare earth metaloxide.

Mask tables MT according to embodiments of the invention advantageously reduce or avoid capillary adhesion forces, which could cause a mask MA to stick to the mask table MT in an undesirable manner.

In above described embodiments of the invention, when burls are present the layer is provided on distal ends of the burls. Where this is the case, the layer may be omitted from areas in between the burls. This is the case for example in the embodiment depicted in Figure 3, where the layer 24 is not present between the burls. In other embodiments, the layer may be present in areas in between burls. This may be case for example when it is more straightforward to form the layer fully across a surface, including burl distal ends, rather than selectively providing the layer only at burl distal ends.

The layer of embodiments of the invention may be referred to as a hydrophobic layer 24, 30, 50, 54, 58.

In an embodiment, the layer 24, 30, 50, 54, 58 may provide additional roughness to burl distal ends (or other surface). Advantageously, such an embodiment improves resistance to slipping of burls whilst at the same time reducing or avoiding capillary adhesion forces.

Burls may be observed to stick more at some locations than other locations. Such locations may be referred to as locations that are prone to sticking. In an embodiment, the layer may be provided at distal ends of burls at locations that are prone to sticking.

The layer 24, 30, 50, 54, 58 may be provided using a deposition process, for example from a gas phase or a liquid phase. Surfaces and or recess areas, which are not intended to receive the layer 24, 30, 50, 54, 58, may be shielded during the deposition process. For example, the first surface 18 of the substrate support 2 may be shielded.

In one example, the layer 24, 30, 50, 54, 58 can be formed using a HMDS (hexamethyldisilazane) gas. HDMS gas will react with a water-free silicon oxide surface (e.g., burl distal ends) typically at elevated temperatures (120-150°C). Herewith two ammonia molecules will release, while the hydrophobic methyl group will react and will make the surface hydrophobic in nature. That is, a hydrophobic layer is formed.

In order to avoid methyl deposition on the opposite side of the substrate support, that side can be protected by for example a temporary sacrificial coating (e.g., resist), gas flow shielding, or a mechanical seal.

The deposition can be assisted by use of a plasma if required. It is also possible to apply the HMDS by a liquid phase. In this way, the liquid can be applied to a desired surface (e.g., burl distal ends) by wetting the HMDS solution. The application to the desired surface may for example be done by spincoating, dipcoating, inkjet printing or screen printing.

Other methods of providing the layer 24, 30, 50, 54, 58 may be used.

The substrate tables WT and mask tables MT of embodiments of the invention are examples of object tables.

Although the above-described embodiments have primarily been described in relation to use in a DUV lithographic apparatus, it will be appreciated that the above described object supports would also be applicable in, for example, EUV lithographic apparatus.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Aspects of the invention are set out in the clauses below.
1. An object support comprising: a generally planar body having a first surface and having a second surface opposite to the first surface, wherein a first set of burls extend from the first surface, configured to support a substrate, and a second set of burls extend from the second surface; and wherein a layer is provided at distal ends of at least some of the second set of burls, the layer having a static water contact angle of at least 70°.
2. The object support of clause 1, wherein the layer has a static water contact angle of at least 90°.
3. The object support of clause 1 or 2, wherein the layer is formed from monomers.
4.The object support of any preceding clause, wherein the layer is a hexamethyldisilazane (HMDS) based coating, or a coating comprising PTFE (polytetrafluoroethylene), TEOS (tetra orthosilicate), or PDMS (polydimethylsiloxane).
5. The object support of clause 1 or 2, wherein the layer is formed from polymers of rare earth metaloxide.
6. The object support of any preceding clause, wherein the layer is provided at distal ends of all of the second set of burls.
7. The object support of any preceding clause, wherein the second set of burls has a higher density than the first set of burls.
8. The object support of any preceding clause, wherein the layer is provided in areas of the second surface that are located between the second set of burls.
9. The object support of any preceding clause, wherein the layer has a thickness of at least 5 nm.
10. An object table comprising: a base having a planar surface; and an object support comprising a generally planar body having a set of burls which extend from the generally planar body and are in contact with the base; wherein a layer is provided on distal ends of at least some of the burls and/or on the planar surface of the base, the layer having a static water contact angle of at least 70°.
11. An object table comprising: a base which defines a rectangular window and includes an object supporting surface; wherein a layer is provided on the object supporting surface, the layer having a static water contact angle of at least 70°.
12. The object table of clause 11, wherein the layer is provided at distal ends of burls which extend from the object supporting surface.
13. The object table of clause 11 or 12, wherein the layer is provided at locations on the object supporting surface which are configured to receive burls of an object supported by the object table.
14. The object table of any of clauses 10 to 13, wherein the layer has a static water contact angle of at least 90°.
15. The object table of any of clauses 10 to 14, wherein the layer is formed from monomers.
16. The object table of any of clauses 10 to 14, wherein the layer is formed from polymers of rare earth metaloxide.
17. A semiconductor manufacturing apparatus comprising the object support or the object table according to any preceding clause.
18. A patterning device comprising burls at a peripheral portion of the patterning device configured to engage with a mask table.
19. The patterning device according to clause 18, wherein a layer is provided at distal end surfaces of the burls.
20. The patterning device according to clause 19, wherein the layer has a static water contact angle of at least 70°.
21. The object support of any of clauses 1 to 9, further comprising a seal provided at the second surface.
22. The object support of any of claims 1 to 9 and 21, further comprising a wear resistant coating provided at the first set of burls.
23. The object table of clause 10, further comprising a seal provided at the planar surface.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An object support comprising:
a generally planar body having a first surface and having a second surface opposite to the first surface, wherein a first set of burls extend from the first surface configured to support a substrate and a second set of burls extend from the second surface; and
wherein a layer is provided at distal ends of at least some of the second set of burls, the layer having a static water contact angle of at least 70°.

2. The object support of claim 1, wherein the layer has a static water contact angle of at least 90°.

3. The object support of claim 1 or claim 2, wherein the layer is formed from monomers.

4. The object support of any preceding claim, wherein the layer is a hexamethyldisilazane (HMDS) based coating, or a coating comprising PTFE (polytetrafluoroethylene), TEOS (tetra orthosilicate), or PDMS (polydimethylsiloxane).

5. The object support of claim 1 or claim 2, wherein the layer is formed from polymers of rare earth metaloxide.

6. The object support of any preceding claim, wherein the layer is provided at distal ends of all of the second set of burls.

7. The object support of any preceding claim, wherein the second set of burls has a higher density than the first set of burls.

8. The object support of any preceding claim, wherein the layer is provided in areas of the second surface that are located between the second set of burls.

9. The object support of any preceding claim, wherein the layer has a thickness of at least 5 nm.

10. An object table comprising:
a base having a planar surface; and
an object support comprising a generally planar body having a set of burls which extend from the generally planar body and are in contact with the base;
wherein a layer is provided on distal ends of at least some of the burls and/or on the planar surface of the base, the layer having a static water contact angle of at least 70°.

11. An object table comprising:
a base which defines a rectangular window and includes an object supporting surface;
wherein a layer is provided on the object supporting surface, the layer having a static water contact angle of at least 70°.

12. The object table of claim 11, wherein the layer is provided at distal ends of burls which extend from the object supporting surface.

13. The object table of claim 11 or claim 12, wherein the layer is provided at locations on the object supporting surface which are configured to receive burls of an object supported by the object table.

14. The object table of any of claims 10 to 13, wherein the layer has a static water contact angle of at least 90°.

15. The object table of any of claims 10 to 14, wherein the layer is formed from monomers.
